Europäisches Patentamt

European Patent Office

Office européen des brevets

(19)

(11) Veröffentlichungsnummer: **0 343 649**

**A1**

## (12) EUROPÄISCHE PATENTANMELDUNG

(21) Anmeldenummer: 89109416.1

(22) Anmeldetag: 24.05.89

(51) Int. Cl.⁴: **H01L 39/24** , **H01L 39/12** , **C23C 14/34** , **C23C 14/08**

(30) Priorität: 24.05.88 DE 3817610

(43) Veröffentlichungstag der Anmeldung:
29.11.89 Patentblatt 89/48

(84) Benannte Vertragsstaaten:
**ES GR**

(71) Anmelder: **Siemens Aktiengesellschaft**
**Wittelsbacherplatz 2**
**D-8000 München 2(DE)**

(72) Erfinder: **Freller, Helmut**
**Steinbergstrasse 34A**
**D-8505 Röthenbach(DE)**
Erfinder: **Härlen, Ulrich, Dipl.-Phys.**
**Eichenring 38**
**D-8551 Röttenbach(DE)**
Erfinder: **Schwarzenbach, Beate**
**Sedanstrasse 4**
**D-8700 Würzburg(DE)**
Erfinder: **Uzel, Yilmaz, Dipl.-Phys.**
**Im Heuschlag 26**
**D-8520 Erlangen(DE)**

(54) **Verfahren zur Herstellung von dünnen Schichten eines Hochtemperatur-Supraleiters und damit hergestellte Schichten.**

(57) Durch Abstäuben eines Targets (15) aus Material vorgegebener Zusammensetzung wird eine Schicht eines Hochtemperatur-Supraleiters (HTSL) auf ein Substrat (20) aufgebracht und durch eine Wärmebehandlung auf eine für die Supraleitung geeignete Struktur und Sauerstoffstöchiometrie eingestellt. Gemäß der Erfindung erfolgt das Abstäuben durch Sputtern mittels eines Magnetrons (10) bei dem das Substrat (20) in geneigter Orientierung in einem Winkel von 45° bis 90° zum Target (15) steht. Vorzugsweise steht das Substrat (20) mit seiner Fläche in senkrechter Orientierung zum Target (15). Es wird bevorzugt ein planares DC-Magnetron (10) verwendet. Bei Einhaltung dieser Bedingungen können texturierte hochtemperatur-supraleitende Schichten auf polykristallinen Substraten hergestellt werden. Dabei weist die jeweils hergestellte Schicht für die Stromtragfähigkeit günstige c-Achsen-Orientierungen auf.

FIG 1

**Verfahren zur Herstellung von dünnen Schichten eines Hochtemperatur-Supraleiters und damit hergestellte Schichten**

Die Erfindung bezieht sich auf ein Verfahren zur Herstellung einer dünnen Schicht eines Hochtemperatur-Supraleiters (HTSL), bei dem durch Abstäuben eines Targets aus Material vorgegebener Zusammensetzung die Schicht auf ein Substrat aufgebracht wird und durch eine Wärmebehandlung eine für die Supraleitung geeignete Struktur und Sauerstoffstöchiometrie eingestellt wird. Sie bezieht sich weiterhin auf die dünne Schicht eines Hochtemperatur-Supraleiters.

Eine wichtige Anwendung der neuen Hochtemperatur-Supraleiter (HTSL) besteht in der Realisierung von supraleitenden Leiterbahnen in elektrischen Bauelementen. Dabei muß insbesondere eine hohe Stromtragfähigkeit des Materials gewährleistet sein, die bisher nur in texturierten oder einkristallinen Schichten beobachtet wird.

Die Herstellung von Filmen aus HTSL-Material kann durch unterschiedliche Verfahren erfolgen, wobei sich insbesondere das Sputtern als geeignet erwiesen hat. Nach der Fachliteratur erfolgt dabei die Präparation der Schichten zur Gewährleistung der Textur bzw. Epitaxie durchweg auf einkristallinen Substraten, die nach hinreichender Vorbehandlung eine geeignete Unterlage für ein orientiertes Wachstum der Schicht bieten. Im Zusammenhang mit hohen kritischen Strömen wurden bei YBaCuO-Supraleitern in den meisten Fällen c-Achsen-Orientierungen beobachtet. Dabei steht die kristallographische c-Achse des Perovskit-Gitters senkrecht auf der Ebene des einkristallinen Substrates. Speziell zur Herstellung von Schichten auf der Basis des Vierstoffsystems Yttrium-Barium-Kupfer-Sauerstoff werden als Substrat insbesondere Strontiumtitanat ($SrTiO_3$) oder Magnesiumoxid (MgO) verwendet, die bezüglich Gitterkon stanten und thermischem Ausdehnungsverhalten diesem HTSL-Material angepaßt sind.

Schichten hoher Stromtragfähigkeit wurden bisher also ausschließlich auf einkristallinen Substraten, insbesondere auf $SrTiO_3$, hergestellt. Der hohe Preis der orientierten $SrTiO_3$-Scheibchen mit der notwendigen, speziellen Oberflächenbehandlung ist nachteilig für eine technische Anwendung. Durch Bindung an einkristalline Substrate sind damit auch die Anwendungsmöglichkeiten der HTSL-Schichten beschränkt.

Aufgabe der Erfindung ist es daher, ein Verfahren zur Herstellung von dünnen Schichten eines Hochtemperatur-Supraleiters anzugeben, mit dem man von der kristallinen Beschaffenheit der Unterlage unabhängig ist. Weiterhin soll auch eine geeignete Schicht angegeben werden.

Die erstgenannte Aufgabe wird erfindungsge mäß dadurch gelöst, daß das Abstäuben durch Magnetron-Sputtern erfolgt, bei dem das Substrat in geneigter Orientierung in einem Winkel von 45° bis 90° zum Target steht. Vorzugsweise ist dabei das Substrat in senkrechter Orientierung zum Target angeordnet und/oder es wird zum Sputtern ein planares DC-Magnetron verwendet.

Die zweitgenannte Aufgabe ist erfindungsgemäß durch eine Schicht eines Hochtemperatur-Supraleiters (HTSL) gelöst, die dadurch gekennzeichnet ist, daß sie auf einem Substrat aus polykristallinem Material hergestellt ist, vorzugsweise nach dem vorstehend genannten Verfahren, und daß sie eine Vorzugsorientierung besitzt.

Mit der Erfindung können supraleitende Schichten mit erhöhter Stromtragfähigkeit auf polykristallinen Substraten erzeugt werden. Bei der erfindungsgemäß geneigten Orientierung der Substrate gegenüber dem Target zeigte sich in jedem Fall eine Textur des aufgestäubten Materials mit einer für die Stromtragfähigkeit günstigen c-Achsen-Orientierung. Dabei handelt es sich um ein überraschendes Phänomen, da im allgemeinen in der Fachliteratur, insbesondere in Berichten über das Magnetron-Sputtern von supraleitenden Schichten, immer dann von der Notwendigkeit einkristalliner Unterlagen ausgegangen wird, wenn hohe Stromtragfähigkeiten erzielt werden sollen.

Die Erfindung erreicht demgegenüber, daß sich offensichtlich durch den streifenden Einfall der Materialteilchen Vorzugsorientierungen auch bei polykristallinen Substrat erreichen lassen. Vorzugsweise werden als Substrate Keramik, insbesondere Zirkonoxid, verwendet. Da nunmehr eine einkristalline Unterlage nicht mehr benötigt wird, kann als Substrat gegebenenfalls auch ein Verbundkörper aus Metall/Keramik gewählt werden, der eine beliebig geformte Oberfläche aufweisen kann.

Weitere Einzelheiten und Vorteile der Erfindung ergeben sich aus der nachfolgenden Beschreibung von Ausführungsbeispielen anhand der Zeichnung. Es zeigen

FIG 1 in schematischer Darstellung die verwendete Beschichtungsanlage mit unterschiedlicher Anordnung der Substrate;

FIG 2 ein Diagramm zur Verdeutlichung der Nachbehandlung der Schichten;

FIG 3 ein Röntgendiffraktogramm einer in der Anlage nach FIG 1 in waagerechter Anordnung beschichteten Substrates;

FIG 4 ein Röntgendiffraktogramm eines vergleichbaren Pulverspektrums;

FIG 5 ein Röntgendiffraktogramm einer in der Anlage nach FIG 1 in senkrechter Anordnung beschichteten Substrates und

FIG 6 ein Röntgendiffraktogramm eines entsprechend berechneten Spektrums mit vollständiger c-Achsen-Orientierung.

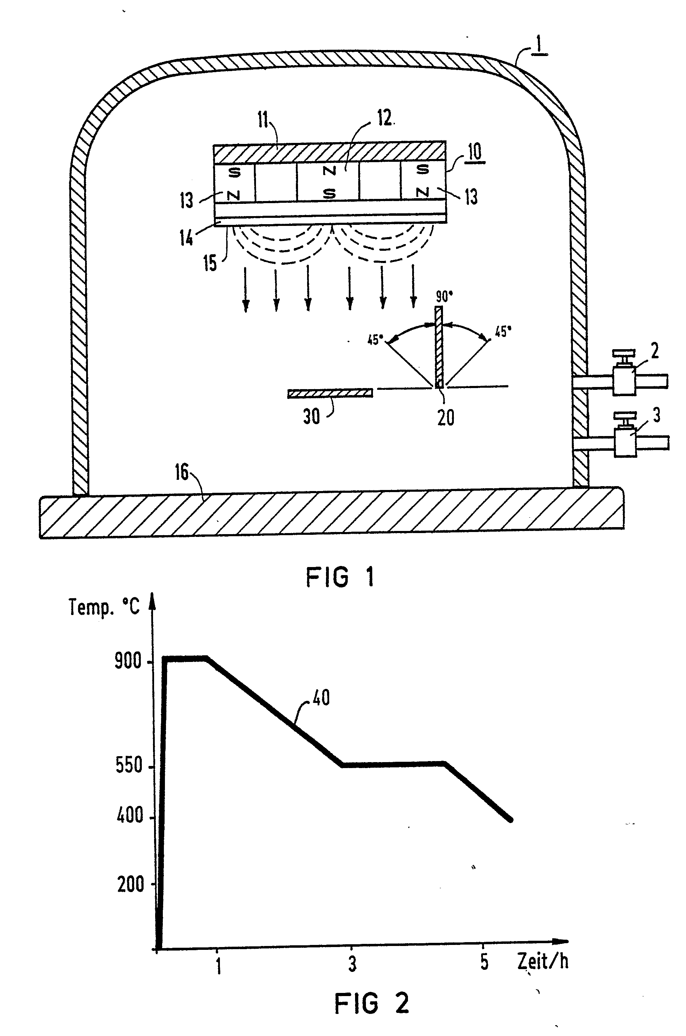

In FIG 1 ist ein Rezipient 1 dargestellt, der ein Ventil 2 für eine Vakuumpumpe und ein Ventil 3 für die Zuführung von Gasen, insbesondere von Argon, aufweist. In dem Rezipienten 1 befindet sich ein Magnetron 10 als Sputterquelle sowie Substrate 20 und 30, auf denen supraleitende Schichten präpariert werden sollen. Die weiteren notwendigen Hilfsmittel, wie insbesondere elektrische Zuleitungen oder Kühlleitungen für das Magnetron und Substratträger bzw. -Manipulatoren, sind in FIG 1 nicht dargestellt.

Als Magnetron 10 ist ein planares DC-Magnetron verwendet. Dies besteht aus einem scheibenförmigen wassergekühlten Grundkörper 11, auf dem konzentrisch ein Magnetsystem mit zentrischem südpolorientierten Magneten 12 und ringförmig im Abstand darumlaufenden nordpolorientierten Magneten 13 angeordnet sind. Der Grundkörper 11 dient dabei als magnetischer Rückschluß. Angedeutet sind die vor dem Magnetsystem 12, 13 verlaufenden Feldlinien. Dem Grundkörper 11 gegenüberliegend ist auf dem Magnetsystem 12, 13 eine Kathode 14 angeordnet. Als Kathode wird ein Körper des abzustäubenden Materials verwendet, das üblicherweise als Target bezeichnet wird und einen austauschbaren Körper 15 vor dem Magnetsystem bildet. Als Anode 16 kann eine Grundplatte des Rezipienten 1 oder der ganze Rezipient 1 verwendet werden.

Soweit entspricht die beschriebene Anordnung den bekannten Magnetron-Sputter-Systemen. Üblicherweise wird davon ausgegangen, daß das zu beschichtende Substrat parallel zur Kathode angeordnet ist, um ein hinreichendes Schichtwachstum, Schichtdickengleichmäßigkeit und eine optimale Oberfläche des Filmes zu erhalten. In FIG 1 ist nun ein erstes Substrat 20 mit senkrechter Orientierung zum Target 15 und ein zweites Substrat 30 mit paralleler Orientierung zum Target 15, wie es dem Stand der Technik entspricht, dargestellt. Die Substrate 20 und 30 sind beide aus identischem Material und zwar polykristallinem Zirkonoxid ($ZrO_2$) gewählt, das vor dem Einbau in den Rezipienten einer Reinigungsbehandlung unterzogen worden ist. Auf die unterschiedlich ausgerichteten Substrate 20 und 30 wurden Schichten eines hochtemperatursupraleitenden Materials (HTSL) aufgestäubt.

Als Material für den Hochtemperatur-Supraleiter wurde das bekannte System Yttrium-Barium-Kupfer-Sauerstoff gewählt. In diesem System zeigt die Zusammensetzung $YBa_2Cu_3O_{7-x}$ bekanntermaßen Supraleitung bei 90K. Die Herstellung von Epitaxialschichten dieses Materials beispielsweise durch Aufdampfen oder Aufsputtern ist in der Literatur vielfach beschrieben. Dabei wird im allgemeinen von einkristallinem Strontiumtitanat ($SrTiO_3$)-Substraten ausgegangen, welche wegen der ähnlichen Kristall-Struktur wie das Perovskit-Gitter optimale Voraussetzungen für ein epitaxiales Wachstum bieten. Die aufgebrachte Schicht hat im allgemeinen einen zunächst unterstöchiometrischen Sauerstoffgehalt und ist deshalb nicht supraleitend, wobei durch eine sich anschließende Nachbehandlung in Sauerstoffatmosphäre die für die Supraleitung geeignete Struktur und Sauerstoffstöchiometrie eingestellt wird. Die Nachbehandlung besteht im vorliegenden Fall insbesondere aus einem Temperaturzyklus mit zwei einstellbaren Temperaturen, von denen die höhere Temperatur bei $\geqq$ 850°C liegt.

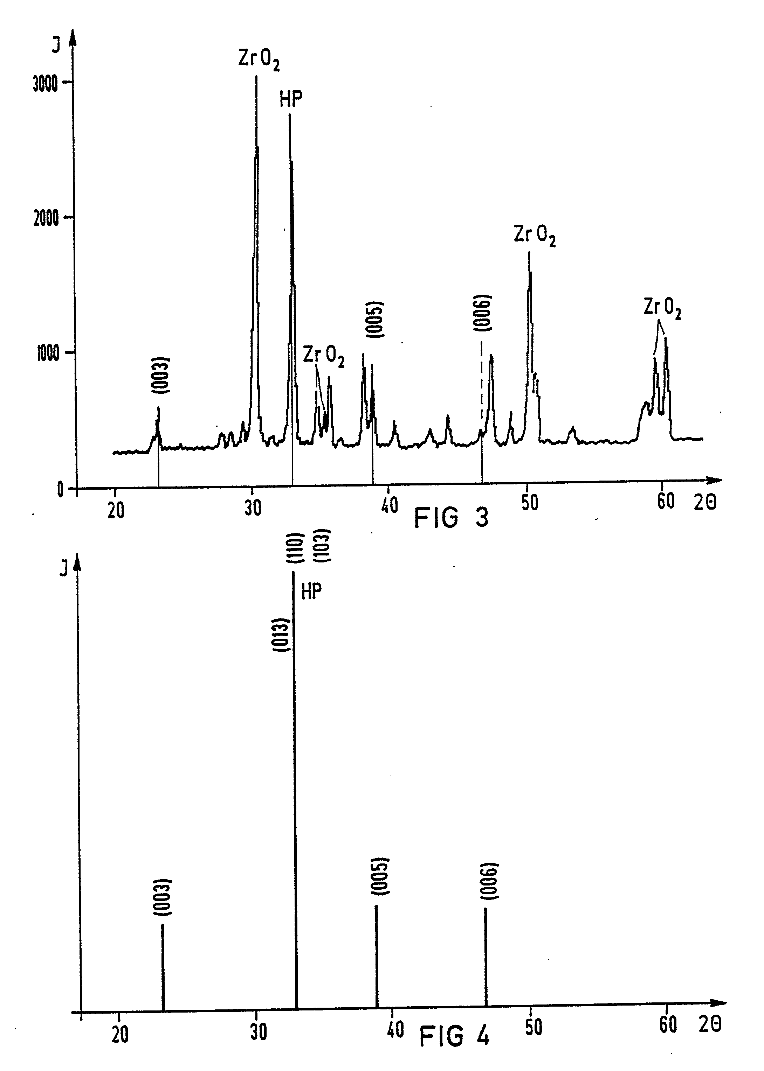

In einer Versuchsreihe wurden die beiden unterschiedlich orientierten Substrate 20 und 30 beschichtet. Nach der Beschichtung wurden die Filme zunächst auf 850 - 900°C aufgeheizt, bei dieser Temperatur eine Stunde in Sauerstoffatmosphäre gehalten und anschließend mit einer Abkühlgeschwindigkeit von 2K/min auf ca. 500°C abgekühlt und bei dieser Temperatur unter Sauerstoffatmosphäre eine Stunde gehalten. In FIG 3 ist ein derartiger zweistufiger Temperaturzyklus dargestellt: Der Graph 40 bedeutet den Temperaturverlauf in einem Temperatur-Zeit-Diagramm, der zur Nachbehandlung der Schichten vorgegeben wurde. Einem schnellen Temperaturanstieg, der beispielsweise durch Einbringen der Probe in den auf Solltemperatur vorgewärmten Ofen erreicht wird und etwa einem Anstieg von 100 K/min entspricht, folgt eine erste, kürzere Haltezeit bei hoher Temperatur, beispielsweise 900°C, und nach langsamem Abkühlen im Bereich von 1 bis 3 K/min eine zweite, längere Haltezeit bei mittlerer Temperatur, beispielsweise 550°C. Nach Abschalten des Ofens bleiben die Proben weiter im Sauerstoffstrom, bis mindestens 400°C erreicht ist.

Bei allen Proben bildet sich die supraleitende Phase aus mit dem für dieser Stoffklasse üblichen $T_c$-Bereich. An den Proben wurden anschließend Röntgenfeinstrukturuntersuchungen durchgeführt und die Stromtragfähigkeit gemessen.

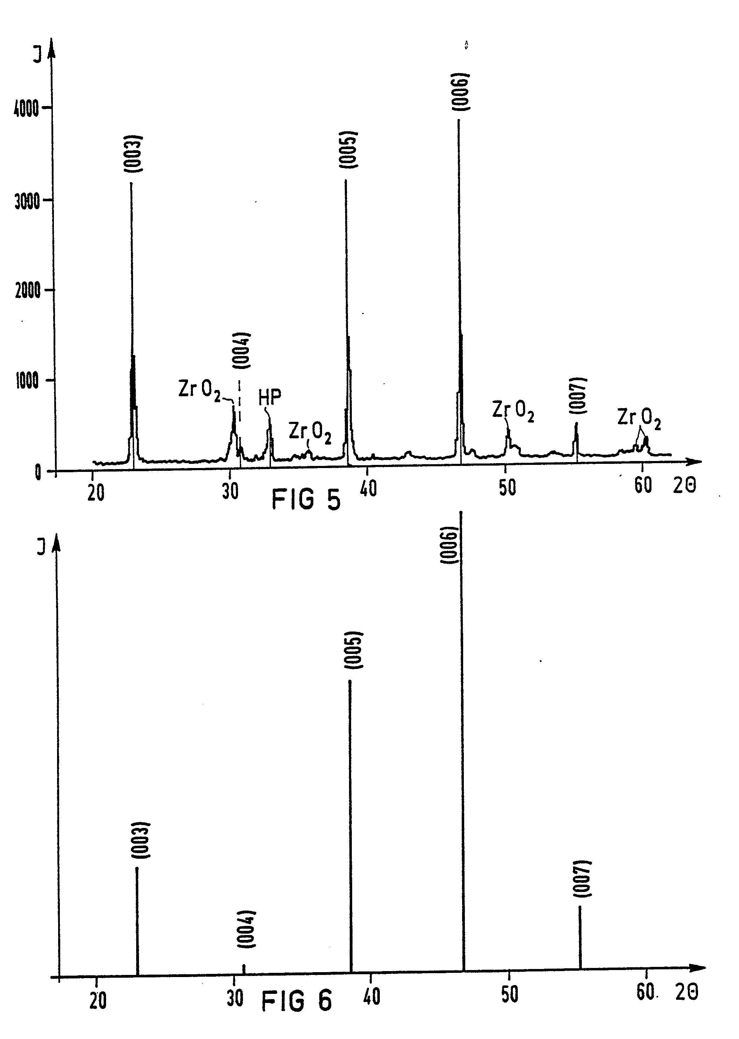

In den Figuren 3 bis 6 sind die relativen Intensitäten als Funktion des Beugungswinkels 2θ dargestellt. Dabei zeigen jeweils die Figuren 2 und 4 die Originalmeßkurven, während die Diffraktogramme der Figuren 4 und 6 aus der Literatur entnommen sind und nur schematisch dargestellt sind.

Das Röntgendiffraktogramm gemäß FIG 3 von der gegenüber dem Target 15 parallel orientierten Probe 30 gemäß FIG 3 zeigt ein Spektrum vergleichbar dem Pulverspektrum von $YBa_2Cu_3O_{7-x}$,

wobei darüber hinaus dem Substratmaterial $ZrO_2$ zuordbare Reflexe zu erkennen sind. Vergleicht man die Meßkurve mit einem Pulverspektrum aus der Literatur (Jap. J. Appl. Phys. 26 (6), L 1066 (1987)) gemäß FIG 4, so ergibt sich weitgehende Identität. Insbesondere liegt bei einem Beugungswinkel von 32° in beiden Fällen eine starke Intensität vor, die den Beugungsreflexen (013), (103) und (110) zugeordnet werden kann. Weiterhin liegt Intensität bei den Reflexen (003), (005) und (006) vor.

Die Schicht auf der zum Target 15 parallel orientierten Probe 30 ist also nicht texturiert oder vorzugsorientiert. Die Messung der Stromtragfähigkeit ergab demzufolge niedrige Werte.

Im Röntgendiffraktogramm gemäß FIG 5 liegen dagegen bei drei unterschiedlichen Beugungswinkel starke Intensitäten, und bei drei weiteren Punkten schwache Intensitäten vor. Beim Beugungswinkel von 32° kann eine schwache Intensität dem (013), (103), (110)-Reflex zugeordnet werden ,die dem Hauptpeak aus FIG 3 entspricht. Die indizierten (00L)-Reflexe deuten auf eine starke Vorzugsorientierung hin.

Vergleicht man das Diffraktogramm gemäß FIG 5 mit FIG 6, in der ein aus der Literatur (Jap. J. Appl. Phys. 26 (9), L 1484 (1987)) berechnetes Diffraktogramm für eine c-Achsen-Orientierung wiedergegeben ist, so lassen sich die übrigen Intensitäten den (003)-, (004)-, (005)-, (006)-, (007)-Reflexen zuordnen.

Es ergibt sich also überraschenderweise, daß die in senkrechter Lage auf polykristallinen $ZrO_2$-Substraten beschichteten Proben eine c-Achsen-Orientierung aufweisen. Dies wird durch Strommessungen bestätigt, die eine um einen Faktor vier bis fünf erhöhte Stromtragfähigkeit verglichen mit der in paralleler Orientierung beschichteten Probe zeigen.

Eine Texturierung von supraleitenden Dünnfilmen auf polykristallinen Substraten wird mit vorliegender Erfindung erstmalig beobachtet. Sie wird dem stark streifenden Einfall der Teilchen auf dem Substrat beim Sputtern und dem schnellen Aufheizen beim Temperzyklus gemäß Figur 2 zugemessen. Demzufolge kann die Orientierung des Substrates 20 gegenüber dem Target 15 in einem vorgegebenen Winkelbereich zwischen 45 und 90° variiert werden.

Statt Zirkonoxid als Substrat können gegebenenfalls auch Aluminiumoxid ($Al_2O_3$) oder andere keramische Materialien verwendet werden. Es erscheint aber auch möglich, metallische Substrate zu wählen oder insbesondere einen Verbundkörper Metall/Keramik, bei dem auf einer Metallunterlage zunächst eine Zirkonoxidschicht aufgebracht ist. Dies eröffnet die Möglichkeit einer weitgehend beliebigen Geometrie des Substrates 20.

In FIG 1 ist das Substrat 20 in senkrechter Orientierung zum Target 15 etwa am Rand des Targets angeordnet. Es hat sich herausgestellt, daß die laterale Lage des Substrates keinen Einfluß auf die Schichtbeschaffenheit hat. Demzufolge können auch eine Mehrzahl von Substraten parallelgestellt in senkrechter Orientierung zum Target gleichzeitig beschichtet werden. Dabei scheint der Abstand des Substrates 20 vom Target keine entscheidende Rolle zu spielen. Er kann zwischen zwei und sieben Zentimeter betragen; ein Abstand von fünf Zentimeter hat sich als optimal erwiesen.

Die Komponenten der HTSL-Targets 15 werden bei Sputterprozessen, je nach Verfahren (HF, Magnetron, etc.) und Prozeßparameter, nicht in der ursprünglichen Zusammensetzung in der Schicht 20 wiedergefunden. Daher werden in der Regel für die Erzeugung stöchiometrischer Schichten Targets 15 verwendet, die beim System $YBa_2Cu_3O_{7-x}$ von der 1-2-3-Stöchiometrie abweichen. Eine für das erfindungsgemäße Verfahren günstige Zusammensetzung ist $YBa_6Cu_{10}O_{18-y}$. Obwohl der Bariumgehalt immer so gering wie möglich gewählt werden sollte, ist eine Überstöchiometrie im Vergleich zur fertigen Schicht notwendig. Dabei liegt der sinnvolle Bereich für das Barium zwischen dem 1,5- und 3-fachen Wert der stöchiometrischen Zusammensetzung $YBa_2Cu_3O_{7-x}$. Speziell Targets mit Zusammensetzungen des Bariums in diesem Bereich und daran angepaßten Zusammensetzungen des Kupfers lassen bei entsprechender Verfahrensführung diesbezügliche HTSL-Schichten mit Vorzugsorientierung erwarten.

## Ansprüche

1. Verfahren zur Herstellung einer dünnen Schicht eines Hochtemperatur-Supraleiters (HTSL), bei dem durch Abstäuben eines Targets aus Material vorgegebener Zusammensetzung die Schicht auf ein Substrat aufgebracht wird und durch eine Wärmebehandlung eine für die Supraleitung geeignete Struktur und Sauerstoffstöchiometrie eingestellt wird, **da durch gekennzeichnet**, daß das Abstäuben durch Magnetron-Sputtern erfolgt, bei dem das Substrat in geneigter Orientierung in einem Winkel von 45° bis 90° zum Target steht.

2. Verfahren nach Anspruch 1, **dadurch gekennzeichnet**, daß das Substrat in senkrechter Orientierung zum Target steht.

3. Verfahren nach Anspruch 1 oder Anspruch 2, **dadurch gekennzeichnet**, daß ein planares DC-Magnetron verwendet wird.

4. Verfahren nach einem der Ansprüche 1 bis 3, **dadurch gekennzeichnet**, daß der Abstand des Substrates vom Target zwischen zwei und sieben Zentimeter, vorzugsweise bei fünf Zentimeter liegt.

5. Verfahren nach einem der vorhergehenden Ansprüche, **dadurch gekennzeichnet**, daß als Substrat polykristallines Material verwendet wird.

6. Verfahren nach Anspruch 5, **dadurch gekennzeichnet**, daß das polykristalline Material Keramik ist.

7. Verfahren nach Anspruch 6, **dadurch gekennzeichnet**, daß die Keramik Zirkonoxid ($ZrO_2$) ist.

8. Verfahren nach Anspruch 5, **dadurch gekennzeichnet**, daß das polykristalline Material ein Verbundkörper aus Metall und Keramik ist.

9. Verfahren nach einem der vorhergehenden Ansprüche, wobei das Material des Hochtemperatur-Supraleiters $YBa_2Cu_3O_{7-x}$ ist, **dadurch gekennzeichnet**, daß das Target eine Zusammensetzung aufweist, die von der Zusammensetzung des $YBa_2Cu_3O_{7-x}$ abweicht.

10. Verfahren nach Anspruch 9, **dadurch gekennzeichnet**, daß das Target einen Bariumgehalt aufweist, der zwischen dem 1,5- und dem 3-fachen Wert des $YBa_2Cu_3O_{7-x}$ liegt.

11. Verfahren nach einem der Ansprüche 9 oder 10, **dadurch gekennzeichnet**, daß das Target die Zusammensetzung $YBa_6Cu_{10}O_{18-y}$ aufweist.

12. Verfahren nach einem der Ansprüche 1 bis 11, **dadurch gekennzeichnet**, daß die Wärmebehandlung der Schicht mit einer vorgegebenen ersten Haltezeit bei einer ersten Temperatur $\geq$ 850°C, vorzugsweise bei etwa 900°C, unter Luft oder Sauerstoff erfolgt.

13. Verfahren nach Anspruch 12, **dadurch gekennzeichnet**, daß die Wärmebehandlung in einem zweistufigen Temperaturzyklus mit einer zweiten Haltezeit bei einer zweiten Temperatur, die niedriger als die der ersten Temperatur ist, erfolgt.

14. Verfahren nach einem der Ansprüche 12 oder 13, **dadurch gekennzeichnet**, daß bei der Wärmebehandlung zunächst ein schnelles Aufheizen der Schicht, vorzugsweise durch Einbringen der Schicht in einen vorgeheizten Ofen, erfolgt.

15. Verfahren nach einem der Ansprüche 1 bis 11, **dadurch gekennzeichnet**, daß die Wärmebehandlung dadurch erfolgt, daß das Substrat beim Sputtern geheizt ist.

16. Schicht eines Hochtemperatur-Supraleiters (HTSL), **dadurch gekennzeichnet**, daß sie auf einem Substrat aus polykristallinem Material hergestellt ist, vorzugsweise nach einem der Ansprüche 1 bis 15, und daß sie eine Vorzugsorientierung besitzt.

17. Schicht nach Anspruch 16, **dadurch gekennzeichnet**, daß sie eine Textur mit Achsen-Orientierung des Perovskit-Gitters hat.

18. Schicht nach Anspruch 16 oder Anspruch 17, **dadurch gekennzeichnet**, daß sie aus $YBa_2Cu_3O_{7-x}$ besteht.

**FIG 1**

**FIG 2**

FIG 3

FIG 4

FIG 5

FIG 6

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | JAPANESE JOURNAL OF APPLIED PHYSICS, Band 26, Nr. 5, Mai 1987, Seiten L738-L740; M. KAWASAKI et al.: "High Tc Yb-Ba-Cu-O thin films deposited on sintered YSZ substrates by sputtering" * Seite L738, Spalte 1, Zeile 16 - Spalte 2, Zeile 6; Seite L739, Spalte 1, Zeilen 2-7 von unten; Tabelle I; Figur 2(d) * | 16,17 | H 01 L 39/24 H 01 L 39/12 C 23 C 14/34 C 23 C 14/08 |
| Y | Idem | 1-7,9, 10,12-15 | |
| A | Idem --- | 18 | |
| Y | APPLIED PHYSICS LETTERS, Band 52, nr. 13, 28. März 1988, Seiten 1098-1100, American Institute of Physics; H.C. LI et al.: "In situ preparation of Y-Ba-Cu-O superconducting thin films by magnetron sputtering" * Seite 1098, Spalte 1, Zeilen 17-33; Seite 1098, Spalte 2, Zeilen 7-29; Seite 1099, Spalte 1, Zeilen 1-24 * | 1-7,9, 10,12-15 | |
| A | Idem --- | 8 | **RECHERCHIERTE SACHGEBIETE (Int. Cl.4)** H 01 L |
| Y | JAPANESE JOURNAL OF APPLIED PHYSICS, Band 26, Nr. 7, Juli 1987, Seiten L1199-L1201; O. MICHIKAMI et al.: "Synthesis of Y-Ba-Cu-O thin films on sapphire substrates by RF magnetron sputtering" * Insgesamt * -/- | 9,10 | |

Der vorliegende Recherchenbericht wurde für alle Patentansprüche erstellt

| Recherchenort | Abschlußdatum der Recherche | Prüfer |
|---|---|---|
| DEN HAAG | 04-09-1989 | MORVAN D.L.D. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument
................................................................
& : Mitglied der gleichen Patentfamilie, übereinstimmendes Dokument

Europäisches
Patentamt

EUROPÄISCHER RECHERCHENBERICHT

Nummer der Anmeldung

EP  89 10 9416

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | Idem | 1,4,11, 15 | |
| A | APPLIED PHYSICS LETTERS, Band 51, Nr. 25, 21. Dezember 1987, Seiten 2146-2148, American Institute of Physics, New York, NY, US; S.I. SHAH et al.: "Superconductivity and resputtering effects in rf sputtered YBa2Cu3O7-x thin films" * Insgesamt * | 1,4,9, 12-14 | |
| A | JAPANESE JOURNAL OF APPLIED PHYSICS, Band 27, Nr. 4, April 1988, Seiten L639-L642; N. TERADA et al.: "Sputter synthesis of Ba2YCu3OyAs-deposited superconducting thin films from stoichiometric target - A mechanism of compositional deviation and its control" * Insgesamt * | 1,2,15 | |
| X | JOURNAL OF APPLIED PHYSICS, Band 62, Nr. 4, 15. August 1987, Seiten 1524-1526, American Institute of Physics; H. KOIMUMA et al.: "Preparation of superconducting thin films of (La1-xSrx)yCuO4-delta" by sputtering" * Seite 1524, Spalte 1, Zeile 10 von unten - Seite 1525, Spalte 2, Zeile 18; Figur 1 * | 16 | RECHERCHIERTE SACHGEBIETE (Int. Cl.4) |
| A | Idem | 1,2,5-7 ,9,15 | |

--- -/-

Der vorliegende Recherchenbericht wurde für alle Patentansprüche erstellt

| Recherchenort | Abschlußdatum der Recherche | Prüfer |
|---|---|---|
| DEN HAAG | 04-09-1989 | MORVAN D.L.D. |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus andern Gründen angeführtes Dokument

    .......................................................................
& : Mitglied der gleichen Patentfamilie, übereinstimmendes
    Dokument

EPO FORM 1503 03.82 (P0403)

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | ADVANCED CERAMIC MATERIALS- CERAMIC SUPERCONDUCTORS, Band 2, Nr. 3B, Juli 1987, ACerS, Westerville, OH, US; P.H. KOBRIN et al.: "Superconducting oxide thin films by ion beam sputtering" * Seite 431, Zeilen 8-13 von unten; Figur 3 * | 16-18 | |
| A | Idem --- | 1,5,6 | |
| A | APPLIED PHYSICS LETTES, Band 52, Nr. 20, 16. Mai 1988, Seiten 1746-1748, American Institute of Physics; A. STAMPER et al.: "Sputter deposition of YBa2Cu3O6+x on alumina and the influence of ZrO2 buffer layers" * Insgesamt * --- | 1,5-8, 12 | |
| A | ADVANCED CERAMIC MATERIALS, Band 2, Nr. 3B, Juli 1987, Seiten 411-421, ACerS; W.T. ELAM et al.: "Plasma sprayed high Tc superconductors" * Absatz II: "Sample preparation" * --- | 8 | RECHERCHIERTE SACHGEBIETE (Int. Cl.4) |
| P,X | APPLIED PHYSICS LETTERS, Band 53, Nr. 5, 1. August 1988, Seiten 444-446, American Institute of Physics; R.L. SANDSTROM et al.: "Reliable single-target sputtering process for high-temperature superconducting films and devices" * Seite 444 - Seite 445, Spalte 1; Figur 1 * | 1,9,15 | |
| P,A | Idem -----  | 12 | |

Der vorliegende Recherchenbericht wurde für alle Patentansprüche erstellt

| Recherchenort | Abschlußdatum der Recherche | Prüfer |
|---|---|---|
| DEN HAAG | 04-09-1989 | MORVAN D.L.D. |